(19) Europäisches Patentamt
European Patent Office
Office européen des brevets

(11) **EP 3 187 835 A1**

(12) **EUROPEAN PATENT APPLICATION**

(43) Date of publication:
**05.07.2017 Bulletin 2017/27**

(51) Int Cl.:
***G01F 1/69*** (2006.01)   ***H05K 7/20*** (2006.01)

(21) Application number: **16204341.8**

(22) Date of filing: **15.12.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **29.12.2015 US 201514982031**

(71) Applicant: **Schneider Electric IT Corporation West Kingston, RI 02892 (US)**

(72) Inventors:
• **VANGILDER, James William**
  **Pepperell, MA 01463 (US)**
• **WARE, Gary R.**
  **Newton, MA 02459 (US)**
• **SPITAELS, James S.**
  **Shrewsbury, MA 01545 (US)**
• **PARDEY, Zachary**
  **Waltham, MA 02453 (US)**

(74) Representative: **Zerbi, Guido Maria**
  **Murgitroyd & Company**
  **Piazza Borromeo, 12**
  **20123 Milano (IT)**

(54) **RACK AIRFLOW MONITORING SYSTEM AND METHOD**

(57)     A rack airflow monitoring system is configured to measure airflow through an equipment rack having a housing and a perforated front door to enable air to flow into an interior of the housing. The system includes a control module, and a plurality of airflow sensors secured to the front door of the equipment rack and coupled to the control module. Each airflow sensor is configured to detect a parameter used to measure airflow and communicate detected parameters to the control module. The control module is configured to obtain temperature, airflow velocity, and airflow directionality from the plurality of airflow sensors at the front door of the equipment rack.

FIG. 1B

EP 3 187 835 A1

**Description**

FIELD OF THE DISCLOSURE

This disclosure relates to air-cooled systems, and particularly to methods and systems directed toward monitoring airflow within an equipment enclosure or rack.

BACKGROUND OF THE DISCLOSURE

Cooling consumes a large part of energy expenditures for data centers. This creates a need to allocate cooling within a data center as efficiently as possible. To reach this goal, many data center operators rely on airflow and temperature sensors to adjust cooling to achieve adequate airflow and temperatures for servers and racks used to support the servers. To estimate airflow, one known method is to assume that the airflow is proportional to a known airflow amount (e.g., from a rack PDU) or estimated rack power, e.g., 125 cfm/kW. While this technique is widely used across the data center community, it is not very accurate. Equipment racks supporting IT equipment may vary in airflow from, such as 40 cfm/kW up to 300 cfm/kW or more. Further, in order to minimize fan power, IT airflow rate typically changes dynamically in response to inlet temperature and current workload.
Another method of estimating airflow is to calculate rack airflow rate from measured inlet and outlet temperatures along with rack power. This technique involves understanding that if the net temperature rise across the rack and power are both known, then the airflow rate is also known from the conservation-of-energy principle (taken from the 1st Law of Thermodynamics). However, it is very difficult to measure the temperature rise across the rack with meaningful accuracy. Measuring rack exhaust temperature is particularly difficult because of the distribution of IT equipment fans that create some regions with high velocity and other "dead spots." This technique calls for a velocity-weighted temperature measurement, which requires a very large number of measurement locations to produce accurate measurements. Furthermore, measurements made closer to a rear door of the rack than the rear of the actual IT equipment will include a large amount of additional entrained air, which should not be included in the energy/airflow calculation.

SUMMARY OF THE DISCLOSURE

One aspect of the disclosure is directed to a rack airflow monitoring system configured to measure airflow through an equipment rack having a housing and a perforated front door to enable air to flow into an interior of the housing. In one embodiment, the system comprises a control module, and a plurality of airflow sensors secured to the front door of the equipment rack and coupled to the control module. Each airflow sensor is configured to detect a parameter used to measure airflow and communicate detected parameters to the control module. The control module is configured to obtain temperature, airflow velocity, and airflow directionality from the plurality of airflow sensors at the front door of the equipment rack.
Embodiments of the system further may include fifteen airflow sensors evenly spaced across the front door of the equipment rack. The plurality of sensors may be secured to a rear door of the equipment rack instead of the front door. The plurality of airflow sensors may be connected to the control module by a plurality of wires. The plurality of airflow sensors may be powered by a battery or a wired connection. The control module may include a microprocessor in communication with equipment rack and/or data center processing equipment. Each airflow sensor may include an elongate tube, a thermistor disposed within an interior of the tube, and a heater provided adjacent to the thermistor within the interior of the tube. Each airflow sensor further may include an LED indicator to inform an operator whether the particular sensor is "hot" or "cold." Airflow rate may be measured using a transient heating and cooling method, with the thermistor being heated up to a known increment above ambient temperature and then allowed to cool at a natural rate, which can be correlated to air velocity. Each airflow sensor further may include a heating element to provide a heat source with which airflow direction may be determined. The heating element may include a resistor. The tube may have a length approximately three times greater than a diameter of the tube. The tube may have a diameter of 0.5 inches and a length of 1.5 inches. The system further may comprise sealing components to seal gaps around the front door or across a server mounting plane to ensure that IT airflow flows through the front door of the equipment rack and is subject to monitoring. The system further may comprise one or more blanking panels to be secured between server mounting rails at locations unoccupied by servers.
Another aspect of the disclosure is directed to a process for determining airflow velocity from an airflow sensor, with the airflow sensor including a thermistor. In one embodiment, the process comprises: performing an initial calibration of the thermistor until a steady-state voltage and a steady-state temperature of the thermistor are achieved; begin a timer; reading a voltage of the thermistor; calculating an ambient temperature of the thermistor; calculating upper and lower voltage thresholds and upper and lower temperature thresholds of the thermistor; applying a source voltage to the thermistor until the voltage reaches the upper voltage threshold; reading the voltage of the thermistor; if the voltage of the thermistor is greater than the upper voltage threshold, then continue applying the source voltage to the thermistor for a predetermined time period; if the voltage of the thermistor is less than the upper voltage, an ending time is recorded, the voltage is removed from the thermistor, and a characteristic cooling time is calculated; and calculating an airflow velocity.

Embodiments of the method further may include determining an airflow direction. Determining the airflow direction may include taking several voltage readings of the thermistor to determine a steady-state ambient temperature, once the a steady-state ambient temperature is achieved, reading a voltage of the thermistor and converting the voltage to a temperature to establish a starting ambient temperature, applying a voltage to a heater in fluid communication with the thermistor, after a short delay, reading a voltage of the thermistor, calculating an ambient temperature of the thermistor, if a temperature increase of the thermistor is above a threshold temperature margin, then the airflow direction is recorded as "inflow," and if a temperature increase is below a threshold temperature margin, then the airflow direction is recorded as "outflow." The threshold temperature margin may be a variable with respect to an expected or recently-measured airflow velocity. The process further may include calculating a total equipment rack airflow by employing a plurality of sensors on a front of the equipment rack.

## BRIEF DESCRIPTION OF THE FIGURES

The accompanying figures are not intended to be drawn to scale. In the figures, each identical or nearly identical component that is illustrated in various figures is represented by a like numeral. For purposes of clarity, not every component may be labeled in every figure. In the figures:

FIG. 1A is a perspective view of an equipment rack having a rack airflow monitoring system of an embodiment of the present disclosure;
FIG. 1B is a perspective view of the equipment rack and the rack airflow monitoring system illustrated in FIG. 1 with a door of the equipment rack in an open position;
FIG. 2 is a diagram of the rack airflow monitoring system;
FIG. 3 is a view of a sensor of the rack airflow monitoring system;
FIG. 4 is a schematic representation of an exemplary airflow output within an equipment rack;
FIG. 5 is a schematic representation of an exemplary temperature output within an equipment rack;
FIGS. 6A-6F are schematic views of exemplary sensor patterns on equipment racks;
FIGS. 7A-7J are schematic views of exemplary IT distributions within equipment racks;
FIG. 8 is a graph showing accuracy of sensor predictions from computational fluid dynamics ("CFD") simulation;
FIG. 9 is a graph showing percent error in CFD simulated time constant and airflow velocity as a function of tube length;
FIG. 10 is a schematic representation of a thermistor drive circuit;
FIG. 11 is a graph of transient thermistor heating and cooling profile;
FIG. 12 is a process flow chart used to determine temperature and velocity from a single thermistor;
FIG. 13 is a process flow chart used to determine inflow or outflow within the rack; and
FIG. 14 is a block diagram of one example of a computer system that may be used to perform processes and functions disclosed herein.

## DETAILED DESCRIPTION OF THE DISCLOSURE

For the purposes of illustration only, and not to limit the generality, the present disclosure will now be described in detail with reference to the accompanying figures. This disclosure is not limited in its application to the details of construction and the arrangement of components set forth in the following description or illustrated in the drawings. The principles set forth in this disclosure are capable of other embodiments and of being practiced or carried out in various ways. In addition, the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items.

Embodiments of the rack airflow monitoring system enable airflow of IT equipment housed within an equipment rack to be continuously monitored and reported to data center management software. While, there has been steady growth in the quantity and quality of measured parameters in the data center (e.g., temperatures, power consumption, cooling-unit-specific data, etc.), airflow rate through an equipment rack is not among them. This is despite the fact that rack airflow rate is one of the most important variables affecting data center cooling and, and therefore, energy consumption. The rack airflow monitoring system is capable of managing and troubleshooting an existing data center, compiling a database of IT airflow with which future facilities may be designed and managed, creating accurate thermal/airflow models of data centers, and optimizing energy-efficiency through control of data center cooling resources. The rack airflow monitoring system is configured to measure airflow using thermistors secured to the equipment rack, which result in airflow measurements being tolerant of dispersed IT populations, highly-variable IT airflow rates, and airflow direction. The system utilizes inexpensive, thermistor-based airflow velocity measurements with the ability to determine airflow direction (e.g., "in" or "out").

For example, for hot-aisle-containment installation systems, it has proven very difficult to control cooling airflow based on hot aisle pressure measurement (the installation system is oftentimes too leaky to provide sufficient hot-aisle suction pressure resolution). Embodiments of the rack airflow monitoring system are easily and efficiently controlled based on the airflow measurements described herein. The rack airflow monitoring system is simple to install and operate, and provides greater efficiency.

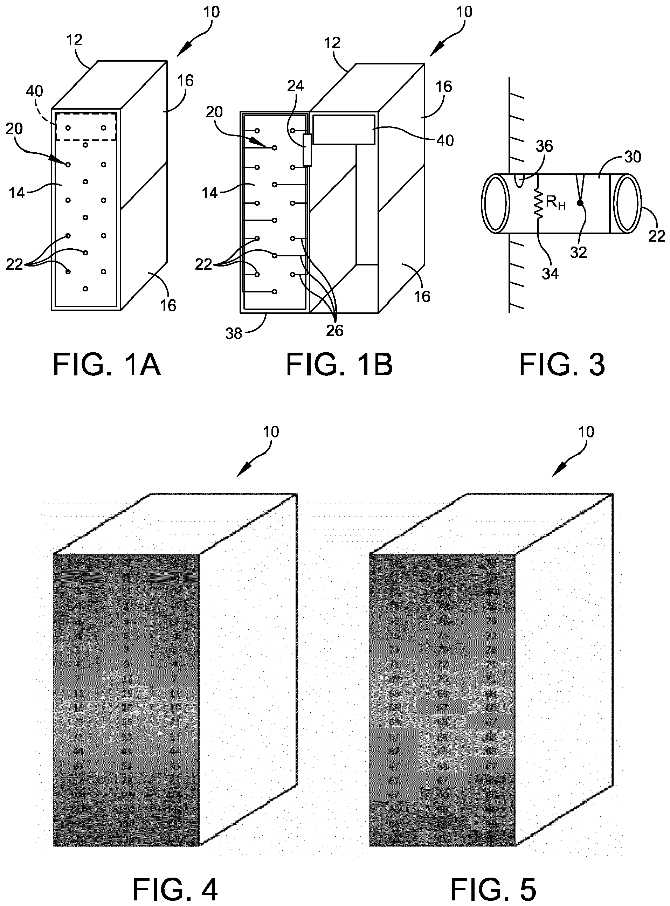

Referring to the drawings, and more particularly to FIGS. 1A and 1B, an exemplary equipment rack is generally indicated at 10. As shown, the equipment rack 10 is of conventional construction, including a rectangular housing 12 having a front door 14 hingedly secured to a front of the housing. The front door 14 includes a perforated panel to allow air to flow into and out of the equipment rack 10. The sides of the housing 12 include panels, each indicated at 16, to channel air through the housing toward a back or rear of the housing. The back of the housing 12 can be configured to include a back or rear door having a perforated panel to allow air to flow out of the equipment rack 10. The equipment rack 10 is configured to support rack-mountable equipment in the traditional manner. In one embodiment, the equipment rack is a 19-inch rack.

To measure airflow, the equipment rack 10 is provided with a rack airflow monitoring system of embodiments of the present disclosure, which is generally indicated at 20. The rack airflow monitoring system 20 is capable of obtaining temperature, airflow velocity, and airflow directionality by a plurality of sensors (sometimes referred to as "airflow sensors"), each indicated at 22, which are distributed over the front door 14 of the equipment rack 10 as illustrated in FIG. 1A. As shown, fifteen airflow sensors 22 are evenly spaced across the front door 14 of the equipment rack 10. As will be described in greater detail below, any number of airflow sensors 22 can be provided to achieve the airflow detection required. Moreover, although reference is made to the airflow sensors 22 being provided on the front door 14 of the equipment rack 10, it should be understood that the rack airflow monitoring system 20 can be configured to be applied to a rear or back door of the equipment rack.

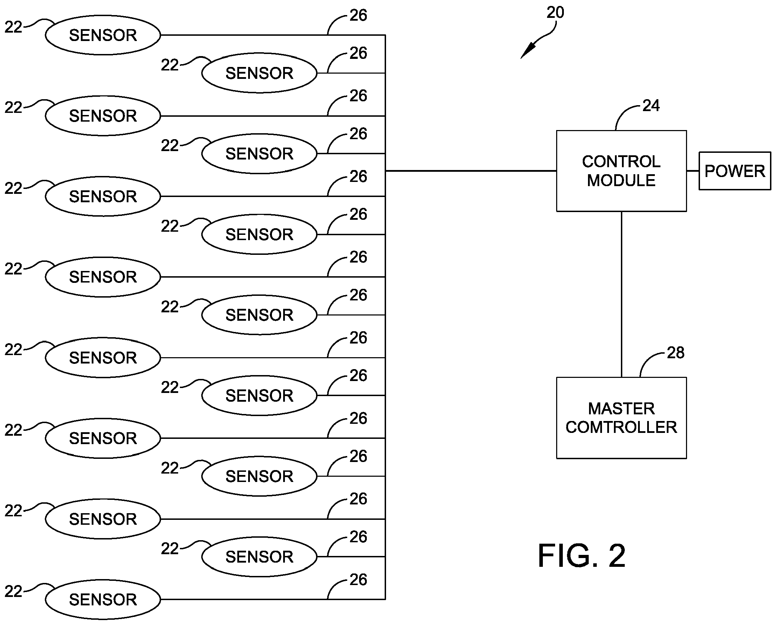

Referring to FIG. 2, the airflow sensors 22 are connected to a control module 24 by wires, each indicated at 26, and may be powered by a battery or a wired connection. As shown, the control module 24 is positioned along a hinge defined by the front door 14 and the housing 12, and may, in one embodiment, be mounted on the front door. In a certain embodiment, the control module 24 can be hardwired to a suitable power source to power the operation of the airflow sensors 22 and the components of the control module. The control module 24 further can include a battery to power the operation of the airflow sensors and the control module in the event that power to the control module is cut off. The control module 24 can be any suitable computer or microprocessor configured to receive, process and forward readings from the airflow sensors. In a certain embodiment, the control module is configured to communicate with a master controller 28 provided within the data center, the master controller having data center management software by a wireless connection. The airflow sensors 22 each consist of a thermistor (for both temperature and velocity measurement) and a resistor (heat source to determine airflow directionality) packaged in a tube so that only airflow perpendicular to the rack face is monitored, which will be described in greater detail below.

Referring to FIG. 3, in the shown embodiment, each airflow sensor 22 includes an elongate tube 30, a thermistor 32 disposed within an interior of the tube, and a heater 34 provided adjacent to the thermistor within the interior of the tube. The thermistor 32 and the heater 34 may be secured to the tube 30 within the interior of the tube by any suitable manner, such as adhesive or glue, or by mechanical fasteners. The airflow sensor 22 further includes an LED indicator 36 to inform an operator whether the particular sensor is "hot" or "cold." Since a resistance of the thermistor 32 is dependent on temperature, a measurement of temperature is achieved by utilizing the thermistor in its typical role. Airflow rate is measured using a transient heating and cooling method of embodiments of the present disclosure, with the thermistor 32 of the airflow sensor 22 being heated up to a known increment above ambient temperature and then allowed to cool at a natural rate, which can be correlated to air velocity. It should be understood that the use of inexpensive thermistors rather than expensive hotwire anemometers renders the system 20 of the present disclosure more practical to deploy. The additional heater (resistor) 34 provides a heat source with which airflow direction ("inflow" or "outflow") may be determined in a manner described in greater detail below.

As mentioned above, the airflow and temperature measurements from the airflow sensors 22 of the rack airflow monitoring system 20 can be transmitted wirelessly to data center management software, such as a StruxureWare® Operations for Data Centers offered by Schneider Electric, or a dedicated computer or mobile application. In addition to net IT airflow through the equipment rack 10 and average temperature of the entering airflow, the distribution of airflow and temperature can be displayed as shown in FIGS. 4 and 5, which illustrates the equipment rack 10 having sixty airflow sensors. FIG. 4 illustrates an exemplary airflow output within the equipment rack 10, where positive numbers correspond to air flowing into the equipment rack and negative numbers correspond to air flowing out of the equipment rack. FIG. 4 shows that, in the example depicted, some airflow leaves the equipment rack 10 through the front face (indicated by a negative sign), i.e., flowing the opposite direction to that expected or desired. FIG. 5 illustrates an exemplary temperature output within the equipment rack 10.

The spatial distribution data gives data center operators the opportunity to assess the uniformity of cooling and, for example, choose to locate IT equipment in particular equipment rack locations accordingly. The airflow and temperature distributions over the front face of the equipment rack may be shown in precise correspondence to the number of airflow sensors (e.g., sixty sensors in the example of FIGS. 4 and 5) or interpolated over the front face of the equipment rack based on measured values. With an accurate IT airflow measurement and known equipment rack power, an accurate net equipment rack temperature rise may also be computed and reported based on an energy balance.

In addition to the display of airflow and temperature data via (remote) software, the rack airflow monitoring system 10 is configured to provide a visual indication of measured quantities through the LED indicators 36 or some other type of local display described above. For example, each airflow sensor 22 is configured with the LED indicator 36, with each LED indicator being configured to be illuminated in "yellow" to identify temperatures between recommended and maximum-allowable values, and being configured to be illuminated in "red" or "green" to identify temperatures that are hotter or cooler, respectively.

In certain embodiments, airflow is measured through the front door 14 (as opposed to the rear door) of the equipment rack 10, since drawing airflow is much smoother and more uniform than driving or forcing airflow, and since the front of the equipment rack between the front door and the front face of the servers (server mounting plane) may be isolated from leakage airflow without great difficulty. The system can be provided with sealing components that are configured to seal any gaps around the front door or across the server mounting plane. FIG. 1B illustrates a seal 38 provided along an outer periphery of the front door 14 to seal the gaps between the front door and the housing 12 when the front door is closed. The sealing of the gaps is provided to ensure that all of the IT airflow passes through the front door 14 of the equipment rack 10 and is, therefore, subject to monitoring. In practice, effective sealing can be achieved with simple weather-stripping and tape in the retrofit scenario. The sealing components can also include blanking panels installed in all unoccupied equipment rack U positions. FIGS. 1A and 1B illustrate two side panels, each indicated at 16, provided on a side of the equipment rack. Blanking panels may be installed on the server mounting plate at the front of the equipment rack 10 and block off areas that otherwise would be occupied by the front faces of the IT equipment. FIGS. 1A and 1B illustrate a blanking panel 40 provided at the top of the equipment rack.

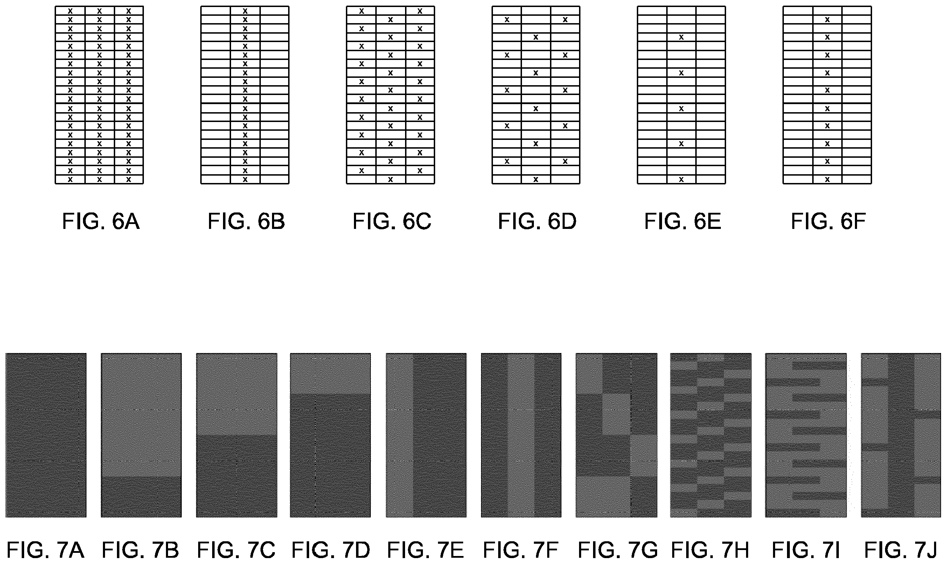

In configuring the system, several factors are considered, including, but not limited to limiting the airflow sensors to a practical and economical number, measuring only the component of airflow which enters or exits (is perpendicular to) the front door, and determining the direction ("in" or "out") of this airflow. In determining sensor distribution, CFD modeling can be employed to determine a good balance between accuracy and sensor count. Models of equipment racks located in different but representative data center environments (e.g., raised-floor cooling with a range of airflow rates, row-based-cooling with a range of airflow rates, positions and orientations relative to other equipment racks, etc.) were created. Exemplary airflow sensor placements are shown in FIGS. 6A-6F, with FIG. 6A showing an embodiment of the rack airflow monitoring system employing sixty airflow sensors, FIG. 6B showing an embodiment of the rack airflow monitoring system employing twenty airflow sensors, FIG. 6C showing an embodiment of the rack airflow monitoring system employing thirty airflow sensors, FIG. 6D showing an embodiment of the rack airflow monitoring system employing fifteen airflow sensors, FIG. 6E showing an embodiment of the rack airflow monitoring system employing five airflow sensors, and FIG. 6F showing an embodiment of the rack airflow monitoring system employing ten airflow sensors.

For each environment, the combinations of sensor distributions and IT populations shown in FIGS. 6A-6F and 7A-7J are simulated. In FIGS. 7A-7J, the darker shaded portions indicate locations of IT equipment airflow, while the lighter shaded portions indicate zero airflow, e.g., blanking panels, "dead" areas on the front of IT equipment, etc. "Virtual sensors" are created in the CFD models at the locations shown in FIGS. 6A-6F. The virtual sensors provide the component of velocity perpendicular to the rack door and indicate (based on sign) whether the flow is "in" or "out". The rack airflow rate is computed as the product of the average of the measured velocities (accounting for inflow and outflow) and the rack front door area. The velocities can instead be weighted differently depending on their locations. For example, the airflow sensors near the edge of the door can be weighted to have less impact on the final airflow calculation than the sensors near the center of the door.

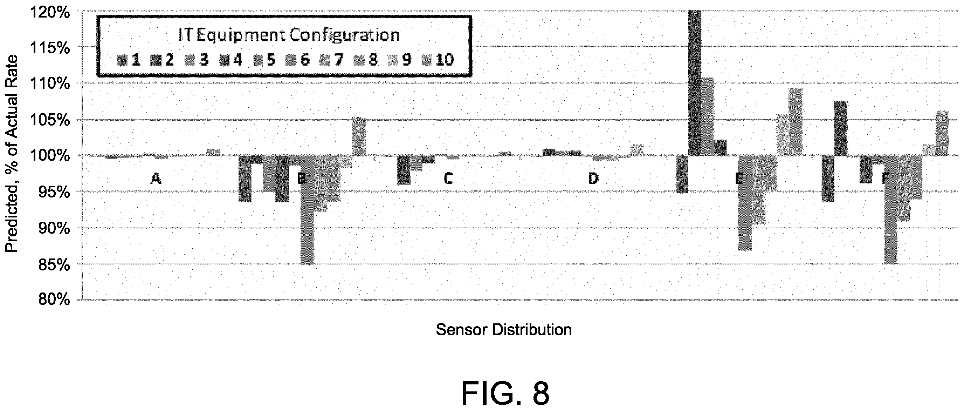

FIG. 8 illustrates the results of a CFD analysis for one particular data center layout, namely a standard raised-floor facility with tile airflow rate of 300 cfm/tile. Other data center layouts (not shown) exhibit similar trends and characteristics. The best accuracy, within ±0.5%, is provided by sensor configuration A, which features 60 evenly spaced sensors and corresponds to the sensor configuration represented in FIG. 6A. However, sensor configuration represented in D, which corresponds to the sensor configuration represented in FIG. 6D, is accurate to within 1.4% of the Sensor Configuration A and requires only 15 sensors, which is economically a more appropriate approach. Consequently, sensor configuration D is a preferred embodiment for the system concept.

One aspect of the configuration of the airflow sensors of the system is to ensure that the perpendicular component is measured by placing the thermistor inside the tube as shown in FIG. 3. In selecting a sensor distribution as described above, the sensor may be configured to achieve ideal results that are not influenced by the presence of a physical sensor. However, in order to select the appropriate tube dimensions, the thermistor and tube assembly are modeled in explicit detail. A first step is to model the tube assembly in isolation so that the rate of cooling or time constant of the thermistor model can be calibrated against velocity just like the physical sensors, which will be discussed in greater detail below. Consequently, several transient CFD simulations are performed in which the thermistor is heated to a prescribed initial value above ambient and then allowed to cool in the presence of a known airflow rate through the tube. The rate of cooling (time constant) is then calibrated against velocity so that the time constant could henceforth be used directly as a proxy for velocity.

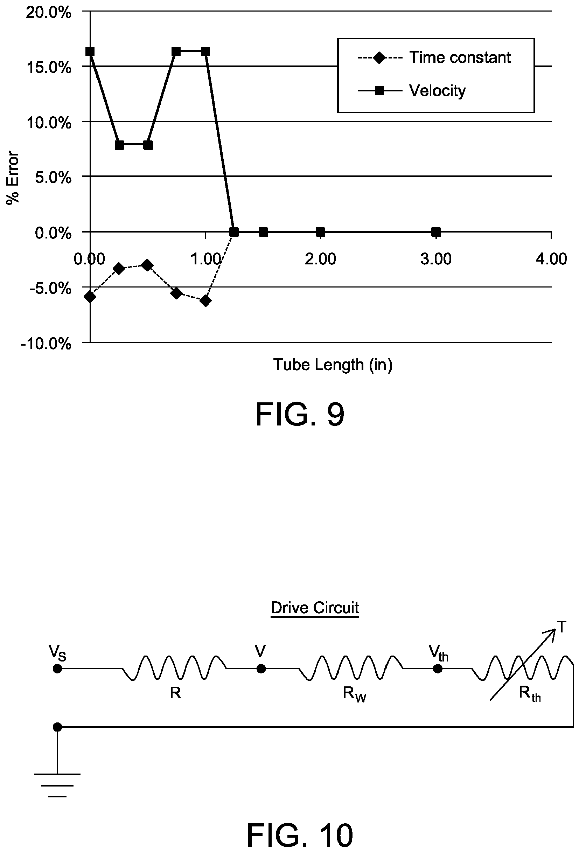

In one embodiment, a tube diameter is 0.5 inch is selected, as this provides a reasonable clearance for the thermistor. Using this fixed diameter (e.g., 0.5 inch), additional (transient) CFD simulations are performed in which the tube length is varied while airflow approached the end of the tube at a worst-case 45 angle relative to the rack front door. In each case, a time constant is recorded, and a corresponding velocity is determined from the known correlation between the time constant and the corresponding velocity. Additionally, the true airflow rate through the tube (in the direction perpendicular to the equipment rack door) is also recorded as measured directly by the CFD model. FIG. 9 shows the results of the thermistor-based velocity predictions as compared to the true values over a range of tube lengths. While there is some non-monotonic behavior at small tube lengths, for tube lengths greater than 1.25 in (a 2.5 length-to-diameter ratio), there is no measurable error. Consequently, for the actual sensors, a more conservative length-to-diameter ratio of 3 (or a tube length of 1.5 in) is selected. However, it should be understood that the size and shape of the tube can be configured to achieve an optimal result.

As shown in FIG. 3, the sensor includes a resistor, which is located to apply heat to the airstream passing through the tube. If the thermistor detects a temperature increase, then the airflow is in the "in" direction, i.e., left-to-right as viewed in FIG. 3. If no temperature rise is detected, then the airflow is in the "out" direction, i.e., right-to-left as viewed in FIG. 3. Note that the amount of temperature rise depends on the airflow (more airflow, less temperature rise and vice versa) so the threshold for recording a temperature rise may be adjusted as a function of airflow rate for better measurement resolution.

Referring to FIG. 10, the thermistor circuit is used for temperature and airflow measurement. $V_s$, $V$, and $V_{th}$ are the applied (source), measured, and thermistor voltages, respectively; $R$, $R_{th}$ and $R_w$ are the dummy (to take voltage measurement), thermistor, and lead wire resistances, respectively. Thermistors are typically used for temperature measurement. While $V$ is measured (rather than $V_{th}$), $V$ and $V_{th}$ can be related by accounting for the wire resistance $R_w$. Since $V_{th}$ is known, or, alternatively, the lead wire resistance is negligible, the lead wire resistance is accounted for in order to improve measurement accuracy. The thermistor resistance $R_{th}$ decreases with increasing temperature - opposite that of standard materials like metals. This relationship is well known and may be expressed, for example, using a simplified Steinhart-Hart Equation:

$$\frac{1}{T_{th}} = \frac{1}{T_0} + \frac{1}{\beta} \ln\left(\frac{v_{th}}{v_0}\right) \tag{1}$$

where $\beta$ is a known constant related to the thermistor construction, and $V_0$ is the measured reference voltage at a known reference temperature $T_0$. Equation 1 provides thermistor temperature as a function of measured voltage $V_{th}$.

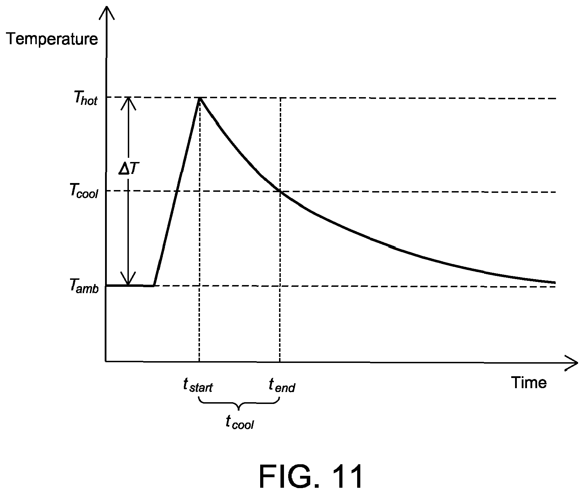

As noted above, airflow velocity measurements are achieved utilizing simple and economical two-wire thermistors, which are heated and allowed to cool in a transient manner. FIG. 11 illustrates the temperature profile of a thermistor during a velocity measurement. The thermistor is heated starting from ambient temperature $T_{amb}$ (or, alternatively, some higher temperature) to $T_{hot}$ and is then allowed to cool naturally by transferring its heat to the airstream passing over it. The shape of the profile under cooling is dictated by a thermal time constant $\tau$ of the thermistor which is defined as:

$$\tau = \frac{Mc_p}{hA} \tag{2}$$

where $M$ is the mass of the thermistor, $c_p$ is the specific heat of the thermistor, $h$ is the heat transfer coefficient to the surrounding fluid, and A is the surface area of the thermistor which is exposed to the surrounding airstream. For a given thermistor, only the heat transfer coefficient $h$ is variable and it depends (strongly) on local airflow velocity. Consequently, the shape of the temperature profile during the cooling phase yields a time constant which, in turn, can be correlated to airflow.

Referring to FIG. 11, for thermistors of a given construction, it is not necessary to compute an actual time constant - which would typically be achieved by fitting multiple temperature-time data points to an exponential function. Instead, airflow velocity $v$ is determined as a function of a single value, $t_{cool}$ - the time it takes for the thermistor to cool by a given temperature drop $T_{hot}$-$T_{cool}$. During the thermistor calibration phase, $v$ is compiled as a function of $t_{cool}$ and, optionally, included an additional minor correction for ambient temperature, $T_{amb}$.

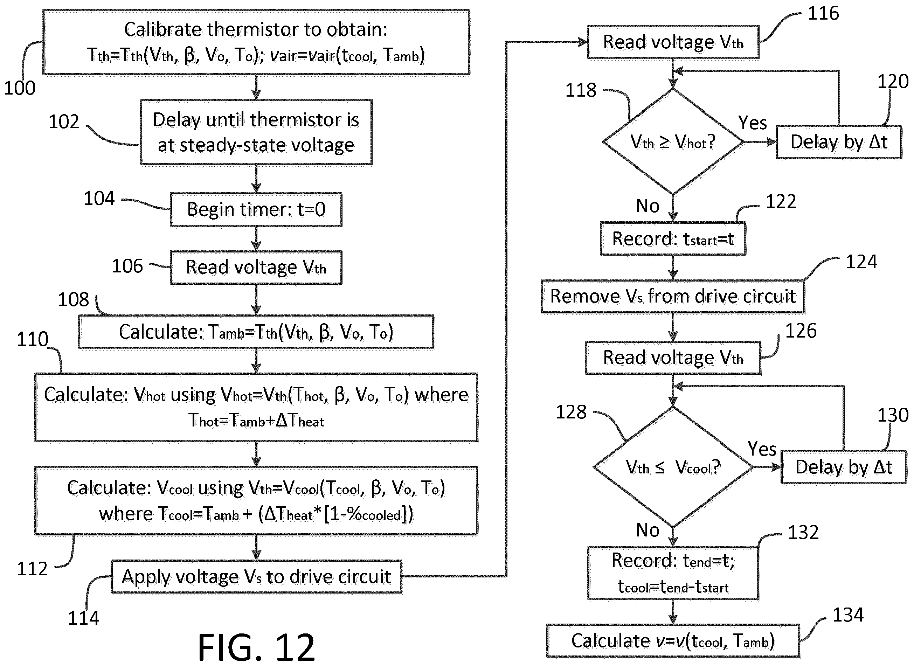

FIG. 12 illustrates a process for determining temperature and airflow velocity from the thermistors. For each thermistor, an initial calibration (Step 100) is performed prior to the construction of the system but included in the process described herein for completeness. The initial calibration is used to determine a threshold temperature and a threshold velocity of airflow passing over the thermistor. The calibration step follows the theory of temperature and airflow measurement with thermistors as discussed above. Voltage readings are made until a steady-state voltage and, therefore, a steady-state temperature is achieved (Step 102). A timer is started (Step 104), and a voltage of the thermistor is measured (Step 106). Next, the voltage is converted to a starting ambient temperature (Step 108). Upper and lower voltage thresholds, $V_{hot}$ and $F_{cool}$, are calculated (Steps 110 and 112), which correspond to $T_{hot}$ and $T_{cool}$ (see FIG. 11), respectively. The lower threshold temperature, $T_{cool}$, is taken based on a percentage drop, e.g., 50%, of the total $\Delta T_{heat}$ where $T_{hot} = T_{amb} + \Delta T_{heat}$.

A source voltage is then applied to the thermistor (Step 114; see FIG. 10) until the voltage is read (Step 116) and reaches $V_{hot}$ (Step 118). If the thermistor voltage exceeds $V_{hot}$, then $T_{th} \leq T_{hot}$, recalling that thermistor resistance (and, therefore, voltage) decreases with increasing temperature, then a continued application of voltage is applied to the thermistor to continue heating for an additional time delay (Step 120). Alternatively, if the measured voltage is less than $V_{hot}$, then, $T_{hot}$ has been reached and the start time, $t_{start}$, is recorded (Step 122). The source voltage is removed (Step 124), and the thermistor voltage is read (Step 126).

If the thermistor voltage is lower than $F_{cool}$ (Step 128), then $T_{th} \geq T_{cool}$, and a delay is applied to let the thermistor temperature fall (Step 130). Alternatively, if the measured thermistor voltage exceeds $C_{cool}$, then the ending time, $t_{end}$, is recorded, and the characteristic cooling time, $t_{cool}$, is computed (Step 132). Finally, the air velocity is computed from the original sensor calibration which relates velocity $v$ to characteristic cooling time $t_{cool}$ with an optional minor correction for ambient temperature (Step 134).

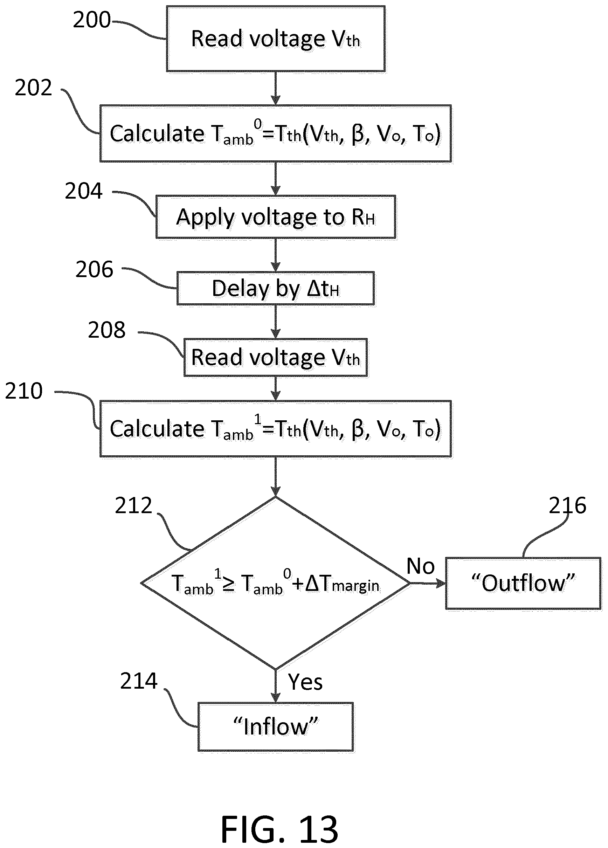

With the sensor assembly shown in FIGS. 1A and 1B, the process for determining the airflow direction through a given sensor is illustrated in FIG. 13. Prior to beginning the process, several thermistor voltage (temperature) readings are taken to ensure that the thermistor is maintained at a reasonably steady-state ambient temperature. Once a steady-state is achieved, the thermistor voltage is read (Step 200), and converted to a temperature (Step 202) in order to establish a starting ambient temperature $T^0_{amb}$. A voltage is applied to the heater resistance $R_H$ (Step 204); after a short delay (Step 206), a new thermistor voltage is read (Step 208) and a corresponding ambient temperature $T^1_{amb}$ (Step 210) is determined. If a temperature increase above some threshold $\Delta T_{margin}$ is detected (Step 212), then the airflow is recorded as "inflow" (Step 9); otherwise it is considered "outflow" (Step 214). Since the temperature rise created by the resistance heater depends on airflow rate, $\Delta T_{margin}$ may be made variable with respect to an expected or recently-measured airflow velocity.

Embodiments of the system disclosed herein include processes for both determining the velocity and flow direction for a single sensor. Assuming that the velocity $v$ is known at every sensor location and is given a positive sign for "inflow" and a negative sign for "outflow", the total rack airflow rate $Q_{net}$ is calculated as:

$$Q = A_{door} \left( \frac{\sum_{i=1}^{n} \alpha_i v_i}{\sum_{i=1}^{n} \alpha_i} \right) \tag{3}$$

where $A_{door}$ is the overall frontal rack open area (i.e., total perforated *area*), $n$ is the number of sensors (e.g., 15), and $\alpha_i$ is a weighting factor associated with each sensor $i$. In the simplest interpretation, the sensors are assumed to be distributed uniformly over the face of the equipment rack and that all sensor locations contribute equally to total airflow rate. In this instance, $\alpha_i = 1$ for all sensors and the total airflow calculation reduces to the product of the open door area and the average velocity of all of the sensors. However, depending on the equipment rack shape, preferred sensor locations, etc., it may be desirable to employ a more complex weighting. In this case, the best values of weighting coefficients may be determined empirically through measurement and or CFD modeling.

Finally, ideally, the equipment rack sensors will provide the same resistance to airflow as the equipment rack front door's perforated openings. This ensures that the airflow will not "avoid" the sensors because they "look like" a larger flow obstruction. The system concept is constructed accordingly; however, it may be possible to calibrate the sensors further by scaling up or down the total airflow rate prediction of Equation 3 accordingly. For example, calibration can include a method of automated, on-board calibration that allows the rack airflow monitoring system to establish, for each individual sensor, the particular cool-down time (or thermal time constant) associated with the condition of a known specified air speed incident upon that particular sensor (where the preferred embodiment is to perform the calibration at zero air speed because that is the easiest condition to produce). Further, a mathematical model that, based on the cool-down time of a particular sensor in relation to the statistical average properties of the batch of sensors from which the sensor originates, maps each of a given sensor's future readings to a modified reading that can be used as an input for the mathematical relationship that maps cool-down time to air speed. Due to manufacturing variability, the cool-down time of a given sensor with a particular air speed incident upon it may vary considerably from any other sensor at the same air speed. This can be an issue when performing the methods disclosed herein. An operator of the system is able to configure the system in such a manner that a known air speed (zero air speed being the preferred embodiment) is incident over all of the airflow sensors, and then have the system record the cool-down time of each airflow sensor at the given air speed. The system is configured to compare the particular cool-down time of each airflow sensor to the average cool-down time for the batch of airflow sensors, and add some correction factor to any future readings from the particular airflow sensor. A correction factor can be determined as the difference between some known sensor population-average cool down time and the cool down time for a particular sensor.

Embodiments of the system can include providing LED lights at each of the fifteen sensor locations (FIG. 1) could be color-coded to agree with, for example, ASHRAE guidelines. For example, blue or green LED lights can be located at the bottom and red LEDs at the top. This provides a nice visual indication in the data center in addition to the communication with management software. In other embodiments, servers in the equipment rack can be automatically located by detecting server "beeps." The system further can include power measurement (rPDU) integrated in the equipment rack. The system further can include more advanced security and access control, e.g., reporting all access events to management software. The airflow measurement concepts disclosed herein can be extended to other data center equipment, namely CRAH units and perforated tiles. This would allow intelligent optimization of the entire data center cooling system.

Various aspects and functions described herein, including the simulation-based optimization methodology discussed above, may be included as specialized hardware or software components executing in one or more computer systems. For example, the computer module 24 and/or one or more acts of the method described above may be performed with a computer, where at least one act is performed in a software program housed in a computer. Non-limiting examples of computer systems include, among others, network appliances, personal computers, workstations, mainframes, networked clients, servers, media servers, application servers, database servers and web servers. Other examples of computer systems may include mobile computing devices, such as cellular phones and personal digital assistants, and network equipment, such as load balancers, routers and switches. Further, aspects may be located on a single computer system or may be distributed among a plurality of computer systems connected to one or more communications networks.

For example, various aspects and functions may be distributed among one or more computer systems configured to provide a service to one or more client computers, or to perform an overall task as part of a distributed system. Additionally, aspects may be performed on a client-server or multi-tier system that includes components distributed among one or more server systems that perform various functions. Consequently, examples are not limited to executing on any particular system or group of systems. Further, aspects and functions may be implemented in software, hardware or firmware, or any combination thereof. Thus, aspects and functions may be implemented within methods, acts, systems, system elements and components using a variety of hardware and software configurations, and examples are not limited to any particular distributed architecture, network, or communication protocol.

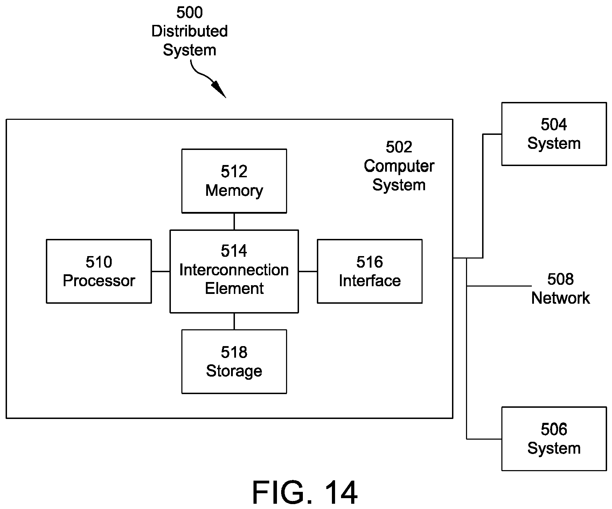

Referring to FIG. 14, there is illustrated a block diagram of a distributed computer system 500, in which various aspects and functions are practiced. As shown, the distributed computer system 500 includes one or more computer systems that exchange information. More specifically, the distributed computer system 500 includes computer systems/devices 502, 504 and 506. As shown, the computer systems/devices 502, 504 and 506 are interconnected by, and may exchange data through, a communication network 508. The network 508 may include any communication network through which computer systems may exchange data. To exchange data using the network 508, the computer systems/devices 502, 504 and 506 and the network 508 may use various methods, protocols and standards, including, among others, Fibre Channel, Token Ring, Ethernet, Wireless Ethernet, Bluetooth, IP, IPV6, TCP/IP, UDP, DTN, HTTP, FTP, SNMP, SMS, MMS, SS7, JSON, SOAP, CORBA, REST and Web Services. To ensure data transfer is secure, the computer systems 502, 504 and 506 may transmit data via the network 508 using a variety of security measures including, for example, TLS, SSL or VPN. While the distributed computer system 500 illustrates three networked computer systems, the distributed computer system 500 is not so limited and may include any number of computer systems and computing devices, networked using any medium and communication protocol.

As illustrated in FIG. 14, the computer system 502 includes a processor 510, a memory 512, an interconnection element 514, an interface 516 and data storage element 518. To implement at least some of the aspects, functions and processes disclosed herein, the processor 510 performs a series of instructions that result in manipulated data. The processor 510 may be any type of processor, multiprocessor or controller. Some example processors include commercially available processors such as an Intel Atom, Itanium, Core, Celeron, or Pentium processor, an AMD Opteron processor, an Apple A4 or A5 processor, a Sun UltraSPARC or IBM Power5+ processor and an IBM mainframe chip.

The processor 510 is connected to other system components, including one or more memory devices 512, by the interconnection element 514.

The memory 512 stores programs and data during operation of the computer system 502. Thus, the memory 512 may be a relatively high performance, volatile, random access memory such as a dynamic random access memory ("DRAM") or static memory ("SRAM"). However, the memory 512 may include any device for storing data, such as a disk drive or other nonvolatile storage device. Various examples may organize the memory 512 into particularized and, in some cases, unique structures to perform the functions disclosed herein. These data structures may be sized and organized to store values for particular data and types of data.

Components of the computer system 502 are coupled by an interconnection element such as the interconnection element 514. The interconnection element 514 may include one or more physical busses, for example, busses between components that are integrated within a same machine, but may include any communication coupling between system elements including specialized or standard computing bus technologies such as IDE, SCSI, PCI and InfiniBand. The interconnection element 514 enables communications, such as data and instructions, to be exchanged between system components of the computer system 502.

The computer system 502 also includes one or more interface devices 516 such as input devices, output devices and combination input/output devices. Interface devices may receive input or provide output. More particularly, output devices may render information for external presentation. Input devices may accept information from external sources. Examples of interface devices include keyboards, mouse devices, trackballs, microphones, touch screens, printing devices, display screens, speakers, network interface cards, etc. Interface devices allow the computer system 502 to exchange information and to communicate with external entities, such as users and other systems.

The data storage element 518 includes a computer readable and writeable nonvolatile, or non-transitory, data storage medium in which instructions are stored that define a program or other object that is executed by the processor 510. The data storage element 518 also may include information that is recorded, on or in, the medium, and that is processed by the processor 510 during execution of the program. More specifically, the information may be stored in one or more data structures specifically configured to conserve storage space or increase data exchange performance. The instructions may be persistently stored as encoded signals, and the instructions may cause the processor 510 to perform any of the functions described herein. The medium may, for example, be optical disk, magnetic disk or flash memory, among others. In operation, the processor 510 or some other controller causes data to be read from the nonvolatile recording medium into another memory, such as the memory 512, that allows for faster access to the information by the processor 510 than does the storage medium included in the data storage element 518. The memory may be located in the data storage element 518 or in the memory 512, however, the processor 510 manipulates the data within the memory, and then copies the data to the storage medium associated with the data storage element 518 after processing is completed. A variety of components may manage data movement between the storage medium and other memory elements and examples are not limited to particular data management components. Further, examples are not limited to a particular memory system or data storage system.

Although the computer system 502 is shown by way of example as one type of computer system upon which various aspects and functions may be practiced, aspects and functions are not limited to being implemented on the computer system 502. Various aspects and functions may be practiced on one or more computers having a different architectures or components than that shown in FIG. 14. For instance, the computer system 502 may include specially programmed, special-purpose hardware, such as an application-specific integrated circuit ("ASIC") tailored to perform a particular operation disclosed herein. While another example may perform the same function using a grid of several general-purpose computing devices running MAC OS X with IBM PowerPC processors and several specialized computing devices running proprietary hardware and operating systems.

The computer system 502 may be a computer system including an operating system that manages at least a portion of the hardware elements included in the computer system 502. In some examples, a processor or controller, such as the processor 510, executes an operating system. Examples of a particular operating system that may be executed include a Windows-based operating system, such as the Windows 8 operating system, available from the Microsoft Corporation, a MAC OS X operating system or an iOS operating system available from Apple Computer, one of many Linux-based operating system distributions, for example, the Enterprise Linux operating system available from Red Hat Inc., a Solaris operating system available from Sun Microsystems, or a UNIX operating systems available from various sources. Many other operating systems may be used, and examples are not limited to any particular operating system.

The processor 510 and operating system together define a computer platform for which application programs in high-level programming languages are written. These component applications may be executable, intermediate, bytecode or interpreted code which communicates over a communication network, for example, the Internet, using a communication protocol, for example, TCP/IP. Similarly, aspects may be implemented using an object-oriented programming language, such as .Net, SmallTalk, Java, C++, Ada, C# (C-Sharp), Python, or JavaScript. Other object-oriented programming languages may also be used. Alternatively, functional, scripting, or logical programming languages may be used.

Additionally, various aspects and functions may be implemented in a non-programmed environment, for example, documents created in HTML, XML or other format that, when viewed in a window of a browser program, can render aspects of a graphical-user interface or perform other functions. Further, various examples may be implemented as programmed or non-programmed elements, or any combination thereof. For example, a web page may be implemented using HTML while a data object called from within the web page may be written in C++ or Python. Thus, the examples are not limited to a specific programming language and any suitable programming language could be used. Accordingly, the functional components disclosed herein may include a wide variety of elements, e.g. specialized hardware, executable code, data structures or objects, which are configured to perform the functions described herein.

In some examples, the components disclosed herein may read parameters that affect the functions performed by the components. These parameters may be physically stored in any form of suitable memory including volatile memory (such as RAM) or nonvolatile memory (such as a magnetic hard drive). In addition, the parameters may be logically stored in a propriety data structure (such as a database or file defined by a user mode application) or in a commonly shared data structure (such as an application registry that is defined by an operating system). In addition, some examples provide for both system and user interfaces that allow external entities to modify the parameters and thereby configure the behavior of the components.

It should be observed that the systems and methods disclosed herein are capable of continuously monitoring the flow rate, direction, and temperature of air passing through IT equipment in an equipment rack. This data, in turn, may be used for, among other things:

1) managing and troubleshooting the existing data center;
2) compiling a database of IT airflow with which future facilities may be designed and managed;
3) accurately inputting thermal/airflow models of the data center, which provide additional design and operational benefits; and
4) controlling data center cooling resources to optimize energy efficiency.

In one embodiment, the system includes fifteen airflow/temperature sensors, distributed across the front door of the equipment rack, which indicate the distribution and aggregate values of rack airflow and inlet temperature. The system can be constructed as a complete equipment rack, a replacement equipment rack front door, or a retrofit to existing equipment racks.

The system includes the ability to continuously measure total rack airflow rate. Airflow measurements are tolerant of dispersed populations of IT equipment and/or highly variable IT airflow rates, and the presence of "reverse" airflow, and strong airflow components parallel to the equipment rack front door. Airflow measurements are made using inexpensive, simple two-wire thermistors using an energy-efficient transient method. Additional resistors provide a heat source which allows the flow direction to be detected.

Those skilled in the art will readily appreciate that the various parameters and configurations described herein are meant to be exemplary and that actual parameters and configurations will depend upon the specific application for which the embodiments directed toward the air flow fault detection methods and system of the present disclosure are used. Those skilled in the art will recognize, or be able to ascertain using no more than routine experimentation, many equivalents to the specific embodiments described herein. For example, those skilled in the art may recognize that embodiments according to the present disclosure may further include a plurality or network of power modules or may include a component of a production process using the power modules. It is, therefore, to be understood that the foregoing embodiments are presented by way of example only and that, within the scope of the appended claims and equivalents thereto, the disclosed air flow fault detection methods and systems may be practiced otherwise than as specifically described. The present systems and methods are directed to each individual feature or method described herein. In addition, any combination of two or more such features, apparatus or methods, if such features, apparatus or methods are not mutually inconsistent, is included within the scope of the present disclosure.

Further, it is to be appreciated various alterations, modifications, and improvements will readily occur to those skilled in the art. Such alterations, modifications, and improvements are intended to be part of this disclosure, and are intended to be within the spirit and scope of the disclosure. For example, an existing process may be modified to utilize or incorporate any one or more aspects of the disclosure. Thus, in some embodiments, embodiments may involve connecting or configuring an existing process to comprise the air flow fault detection methods and systems. For example, an existing air-cooling process may be retrofitted to involve use of a fault detection method in accordance with one or more embodiments. Accordingly, the foregoing description and drawings are by way of example only. Further, the depictions in the drawings do not limit the disclosures to the particularly illustrated representations.

While exemplary embodiments have been disclosed, many modifications, additions, and deletions may be made therein without departing from the spirit and scope of the disclosure and its equivalents, as set forth in the following claims.

**Claims**

1. A rack airflow monitoring system configured to measure airflow through an equipment rack having a housing and a perforated front door to enable air to flow into an interior of the housing, the system comprising:

   a control module; and
   a plurality of airflow sensors secured to the front door of the equipment rack and coupled to the control module, each airflow sensor being configured to detect a parameter used to measure airflow and communicate detected parameters to the control module,
   wherein the control module is configured to obtain temperature, airflow velocity, and airflow directionality from the plurality of airflow sensors at the front door of the equipment rack.

2. The system of claim 1, wherein each airflow sensor includes an elongate tube, a thermistor disposed within an interior of the tube, and a heater provided adjacent to the thermistor within the interior of the tube.

3. The system of claim 2, wherein each airflow sensor further includes an LED indicator to inform an operator whether the particular sensor is "hot" or "cold."

4. The system of claim 2, wherein airflow rate is measured using a transient heating and cooling method, with the thermistor being heated up to a known increment above ambient temperature and then allowed to cool at a natural rate, which can be correlated to air velocity.

5. The system of claim 4, wherein each airflow sensor further includes a heating element to provide a heat source with which airflow direction may be determined.

6. The system of claim 5, wherein the heating element includes a resistor.

7. The system of claim 2, wherein the tube has a length approximately three times greater than a diameter of the tube.

8. The system of claim 7, wherein the tube has a diameter of 0.5 inches and a length of 1.5 inches.

9. The system of claim 1, further comprising sealing components to seal gaps around the front door or across a server mounting plane to ensure that IT airflow flows through the front door of the equipment rack and is subject to monitoring.

10. The system of claim 9, further comprising one or more blanking panels to be secured between server mounting rails at locations unoccupied by servers.

11. A process for determining airflow velocity from an airflow sensor, the airflow sensor including a thermistor, the process comprising:

   performing an initial calibration of the thermistor until a steady-state voltage and a steady-state temperature of the thermistor are achieved;
   begin a timer;
   reading a voltage of the thermistor;
   calculating an ambient temperature of the thermistor;
   calculating upper and lower voltage thresholds and upper and lower temperature thresholds of the thermistor;
   applying a source voltage to the thermistor until the voltage reaches the upper voltage threshold;
   reading the voltage of the thermistor;
   if the voltage of the thermistor is greater than the upper voltage threshold, then continue applying the source voltage to the thermistor for a predetermined time period;
   if the voltage of the thermistor is less than the upper voltage, an ending time is recorded, the voltage is removed from the thermistor, and a characteristic cooling time is calculated; and
   calculating an airflow velocity.

12. The process of claim 11, further comprising determining an airflow direction.

13. The process of claim 12, wherein determining the airflow direction includes
    taking several voltage readings of the thermistor to determine a steady-state ambient temperature,

once the a steady-state ambient temperature is achieved, reading a voltage of the thermistor and converting the voltage to a temperature to establish a starting ambient temperature,
applying a voltage to a heater in fluid communication with the thermistor,
after a short delay, reading a voltage of the thermistor,
calculating an ambient temperature of the thermistor,
if a temperature increase of the thermistor is above a threshold temperature margin, then the airflow direction is recorded as "inflow," and
if a temperature increase is below a threshold temperature margin, then the airflow direction is recorded as "outflow."

14. The process of claim 13, wherein the threshold temperature margin is a variable with respect to an expected or recently-measured airflow velocity.

15. The process of claim 11, further comprising calculating a total equipment rack airflow by employing a plurality of sensors on a front of the equipment rack.

FIG. 1A          FIG. 1B          FIG. 3

FIG. 4          FIG. 5

EP 3 187 835 A1

FIG. 2

FIG. 6A    FIG. 6B    FIG. 6C    FIG. 6D    FIG. 6E    FIG. 6F

FIG. 7A   FIG. 7B   FIG. 7C   FIG. 7D   FIG. 7E   FIG. 7F   FIG. 7G   FIG. 7H   FIG. 7I   FIG. 7J

EP 3 187 835 A1

FIG. 8

EP 3 187 835 A1

FIG. 9

Drive Circuit

FIG. 10

FIG. 11

EP 3 187 835 A1

Calibrate thermistor to obtain:
$T_{th}=T_{th}(V_{th}, \beta, V_o, T_o)$; $v_{air}=v_{air}(t_{cool}, T_{amb})$

100

102 — Delay until thermistor is at steady-state voltage

104 — Begin timer: $t=0$

106 — Read voltage $V_{th}$

108 — Calculate: $T_{amb}=T_{th}(V_{th}, \beta, V_o, T_o)$

110 — Calculate: $V_{hot}$ using $V_{hot}=V_{th}(T_{hot}, \beta, V_o, T_o)$ where $T_{hot}=T_{amb}+\Delta T_{heat}$

Calculate: $V_{cool}$ using $V_{th}=V_{cool}(T_{cool}, \beta, V_o, T_o)$ where $T_{cool}=T_{amb} + (\Delta T_{heat}*[1-\%_{cooled}])$

112 —

114 — Apply voltage $V_s$ to drive circuit

116 — Read voltage $V_{th}$

118 — $V_{th} \geq V_{hot}$? — Yes → Delay by $\Delta t$ — 120

No

122 — Record: $t_{start}=t$

124 — Remove $V_s$ from drive circuit

126 — Read voltage $V_{th}$

128 — $V_{th} \leq V_{cool}$? — Yes → Delay by $\Delta t$ — 130

No

132 — Record: $t_{end}=t$; $t_{cool}=t_{end}-t_{start}$

134 — Calculate $v=v(t_{cool}, T_{amb})$

# FIG. 12

200 — Read voltage $V_{th}$

202 — Calculate $T_{amb}^{0} = T_{th}(V_{th}, \beta, V_o, T_o)$

204 — Apply voltage to $R_H$

206 — Delay by $\Delta t_H$

208 — Read voltage $V_{th}$

210 — Calculate $T_{amb}^{1} = T_{th}(V_{th}, \beta, V_o, T_o)$

212 — $T_{amb}^{1} \geq T_{amb}^{0} + \Delta T_{margin}$

No → 216 — "Outflow"

Yes ↓

214 — "Inflow"

# FIG. 13

500
Distributed
System

502
Computer
System

512
Memory

510
Processor

514
Interconnection
Element

516
Interface

518
Storage

504
System

508
Network

506
System

# FIG. 14

Europäisches
Patentamt

European
Patent Office

Office européen
des brevets

# EUROPEAN SEARCH REPORT

Application Number

EP 16 20 4341

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | GB 2 513 141 A (IBM [US])<br>22 October 2014 (2014-10-22)<br>* figures 1, 2 *<br>* page 1, line 6 - line 8 *<br>* page 5, line 28 - line 33 *<br>* page 2, line 7 - line 10 *<br>----- | 1-10<br><br>15 | INV.<br>G01F1/69<br>H05K7/20 |
| X<br><br>Y<br>A | WO 94/10540 A1 (HUIBERTS ALBERTUS THEODORUS [NL]) 11 May 1994 (1994-05-11)<br>* abstract *<br>* page 12, line 29 - line 32 *<br>* page 20, line 10 - line 22 *<br>* figures 2, 4-6, 12 *<br>* page 22, line 19 - line 20 *<br>* page 25, line 3 - line 6 *<br>* page 21, line 27 - line 32 *<br>* page 18, line 15 - line 20 *<br>* page 6, line 8 - line 22 *<br>* page 23, line 1 - line 4 *<br>* page 13, line 35 - page 14, line 6 *<br>----- | 11,15<br><br>12-14<br>2,4,6-8 | |
| A | US 9 157 812 B1 (GENNELLO ANTHONY W [US]) 13 October 2015 (2015-10-13)<br>* figures 6, 7 *<br>* column 1, line 55 - line 59 *<br>* column 2, line 3 - line 6 *<br>----- | 3 | TECHNICAL FIELDS SEARCHED (IPC)<br><br>G01F<br>G01K<br>H05K |
| | -/-- | | |

The present search report has been drawn up for all claims

| Place of search | Date of completion of the search | Examiner |
|---|---|---|
| The Hague | 18 May 2017 | Régert, Tamás |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 16 20 4341

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y<br>A | US 2002/073774 A1 (KOHNO YASUSHI [JP])<br>20 June 2002 (2002-06-20)<br>* figure 2A *<br>* sentence 10, paragraph 0028 *<br>* paragraph [0010] *<br>* sentence 1, paragraph 0042 - sentence 2 *<br>* sentence 6, paragraph 0044 - sentence 10 *<br>* sentence 1, paragraph 0040 - sentence 10 *<br>* sentence 7, paragraph 0047 - sentence 12 *<br>----- | 12-14<br><br>5 | |
| A | JP 2004 203013 A (FUJI PHOTO FILM CO LTD)<br>22 July 2004 (2004-07-22)<br>* figure 1 *<br>----- | 10 | |
| A | US 2004/139799 A1 (SUDOLCAN DAVID C [US]<br>ET AL) 22 July 2004 (2004-07-22)<br>* the whole document *<br>----- | 1-15 | **TECHNICAL FIELDS<br>SEARCHED (IPC)** |
| A | US 2013/107905 A1 (CAMPBELL LEVI A [US] ET<br>AL) 2 May 2013 (2013-05-02)<br>* the whole document *<br>----- | 1-15 | |

The present search report has been drawn up for all claims

| Place of search | Date of completion of the search | Examiner |
|---|---|---|
| The Hague | 18 May 2017 | Régert, Tamás |

EPO FORM 1503 03.82 (P04C01)

## ANNEX TO THE EUROPEAN SEARCH REPORT
## ON EUROPEAN PATENT APPLICATION NO.

EP 16 20 4341

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2017

| Patent document cited in search report | | Publication date | Patent family member(s) | | Publication date |
|---|---|---|---|---|---|
| GB 2513141 | A | 22-10-2014 | GB 2513141 A | | 22-10-2014 |
| | | | US 2014316720 A1 | | 23-10-2014 |
| WO 9410540 | A1 | 11-05-1994 | AT 150546 T | | 15-04-1997 |
| | | | AU 670162 B2 | | 04-07-1996 |
| | | | CA 2147619 A1 | | 11-05-1994 |
| | | | DE 69309100 D1 | | 24-04-1997 |
| | | | DE 69309100 T2 | | 09-10-1997 |
| | | | EP 0670034 A1 | | 06-09-1995 |
| | | | NL 9201906 A | | 01-06-1994 |
| | | | US 5869758 A | | 09-02-1999 |
| | | | WO 9410540 A1 | | 11-05-1994 |
| US 9157812 | B1 | 13-10-2015 | NONE | | |
| US 2002073774 | A1 | 20-06-2002 | DE 10162592 A1 | | 27-06-2002 |
| | | | JP 4474771 B2 | | 09-06-2010 |
| | | | JP 2002188947 A | | 05-07-2002 |
| | | | US 2002073774 A1 | | 20-06-2002 |
| JP 2004203013 | A | 22-07-2004 | NONE | | |
| US 2004139799 | A1 | 22-07-2004 | AU 2003256747 A1 | | 16-02-2004 |
| | | | CA 2494488 A1 | | 05-02-2004 |
| | | | EP 1585942 A2 | | 19-10-2005 |
| | | | JP 2006509184 A | | 16-03-2006 |
| | | | MX PA05000800 A | | 19-04-2005 |
| | | | US 2004139799 A1 | | 22-07-2004 |
| | | | WO 2004011886 A2 | | 05-02-2004 |
| US 2013107905 | A1 | 02-05-2013 | GB 2498239 A | | 10-07-2013 |
| | | | US 2013107905 A1 | | 02-05-2013 |
| | | | US 2014064320 A1 | | 06-03-2014 |

EPO FORM P0459

For more details about this annex : see Official Journal of the European Patent Office, No. 12/82